# EUROPÄISCHE PATENTANMELDUNG

(11) **EP 4 790 544 A1**
(43) Veröffentlichungstag der Anmeldung: **12.08.2026**
(21) Anmeldenummer: 25156104.9
(22) Anmeldetag: 05.02.2025
(51) Int. Cl.: G06F 7/58, H10D 88/00, H10F 39/00

(54) **ENTROPIEQUELLE FÜR EINEN INTEGRIERTEN QUANTEN-ZUFALLSZAHLENGENERATOR**

(71) Anmelder: Elmos Semiconductor SE, 51379 Leverkusen (DE)
(72) Erfinder: Rotter, Thomas, 91077 Neunkirchen am Brand (DE); Kölbel, Julia, 44137 Dortmund (DE)
(74) Vertreter: Wenzel Nemetzade Warthmüller Patentanwälte Part mbB

(57) **Zusammenfassung**

Es wird eine Entropiequelle für einen integrierten Quanten-Zufallszahlengenerator (10) aufgezeigt, die folgendes umfasst: eine Photonenquelle (40) und einen Einzelphotonendetektor (50), wobei die Photonenquelle (40) und der Einzelphotonendetektor (50) in vertikaler Richtung übereinander in einem gemeinsamen Substrat (20) aus einem Halbleitermaterial angeordnet sind, dadurch gekennzeichnet, dass der Einzelphotonendetektor (50) eine mittels Hochenergie-Ionenimplantation erzeugte dotierte Schicht als Teil eines p-n-Übergangs (54) umfasst.

## Beschreibung

Die Erfindung betrifft eine Entropiequelle für einen integrierten Quanten-Zufallszahlengenerator.

### Stand der Technik

Ein integrierter Quanten-Zufallszahlengenerator mit einer Entropiequelle ist beispielsweise aus der LU 505175 A1 bekannt.

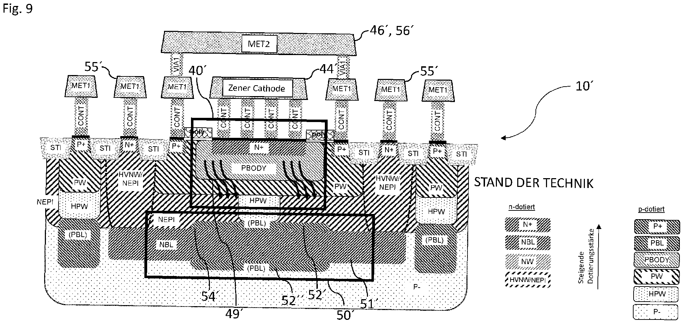

Fig. 9 zeigt eine schematische Darstellung einer Entropiequelle eines integrierten Quanten-Zufallszahlengenerator gemäß dem Stand der Technik in einer Seitenansicht. Die Zeichnung stammt aus der LU 505175 A1.

Die Entropiequelle 10' umfasst eine Photonenquelle 40' und einen Einzelphotonendetektor 50', die in einem gemeinsamen Substrat angeordnet sind. Die Photonenquelle 40' und der Einzelphotonendetektor 50'sind vertikaler Richtung übereinander in dem gemeinsamen Substrat angeordnet.

Die Photonenquelle 40' sendet einzelne Photonen aus, die von dem Einzelphotonendetektor 50' erfasst werden. Die Photonenquelle 40' weist einen p-n-Übergang auf. Der Einzelphotonendetektor 50' weist zwei p-n-Übergänge 54' auf, nämlich einen von der NBL-Schicht 51' zu der oberen PBL-Schicht 52' und einen von der NBL-Schicht 51' zu der unteren PBL-Schicht 52".

Die Entropiequelle des integrierten Quanten-Zufallszahlengenerators in der LU 505175 A weist eine Vielzahl von dotierten Schichten bzw. Gebieten in einem teilweise epitaktisch gebildeten Substrat. Daher ist der integrierte Quanten-Zufallszahlengenerator technisch aufwendig und die Herstellungskosten hoch.

### Offenbarung der Erfindung

Der Erfindung liegt die Aufgabe zu Grunde, eine Entropiequelle für einen integrierten Quanten-Zufallszahlengenerator bzw. einen integrierten Quanten-Zufallszahlengenerator bzw. eine integrierte elektronische Schaltung, der bzw. die technisch einfach aufgebaut ist und kostengünstig ist, bzw. ein Verfahren bereitzustellen, das technisch einfach und kostengünstig ausführbar ist.

Diese Aufgabe wird durch eine Entropiequelle für einen integrierten Quanten-Zufallszahlengenerator gemäß Anspruch 1 gelöst.

Insbesondere wird die Aufgabe durch eine Entropiequelle für einen integrierten Quanten-Zufallszahlengenerator gelöst, wobei die Entropiequelle umfasst: eine Photonenquelle und einen Einzelphotonendetektor, wobei die Photonenquelle und der Einzelphotonendetektor in vertikaler Richtung übereinander in einem gemeinsamen Substrat aus einem Halbleitermaterial angeordnet sind, wobei der Einzelphotonendetektor eine mittels Hochenergie- lonenimplantation erzeugte dotierte Schicht als Teil eines p-n-Übergangs umfasst.

Vorteilhaft hieran ist, dass die Entropiequelle für den integrierten Quanten-Zufallszahlengenerator technisch besonders einfach aufgebaut ist. Zudem ist die Entropiequelle kostengünstig herstellbar. Insbesondere kann die Entropiequelle weniger dotierte Schichten bzw. Gebiete im Vergleich zum Stand der Technik aufweisen, so dass die Herstellung stark vereinfacht ist.

Die Aufgabe wird auch durch einen integrierten Quanten-Zufallszahlengenerator mit einer solchen Entropiequelle gelöst. Die Vorteile des integrierten Quanten-Zufallszahlengenerator entsprechend im Wesentlichen den oben beschriebenen Vorteilen der Entropiequelle.

Die Aufgabe wird auch durch eine integrierte elektronische Schaltung umfassend einen integrierten Quanten-Zufallszahlengenerator wie oben beschrieben gelöst. Die Vorteile der integrierten elektronischen Schaltung entsprechen im Wesentlichen den oben beschriebenen Vorteilen der Entropiequelle bzw. des integrierten Quanten-Zufallszahlengenerators.

Die Aufgabe wird auch durch ein Verfahren zum Herstellen einer Entropiequelle für einen integrierten Quanten-Zufallszahlengenerator, insbesondere einer Entropiequelle wie oben beschrieben, gelöst, wobei das Verfahren folgende Schritte umfasst: Bereitstellen eines Substrats; und Erzeugen von mehreren dotierten Schichten zur Erzeugung eines p-n-Übergangs einer Photonenquelle und eines p-n-Übergangs eines Einzelphotonendetektors in dem Substrat, wobei die Photonenquelle und der Einzelphotonendetektor in vertikaler Richtung übereinander in dem Substrat angeordnet sind, und wobei eine dotierte Schicht des p-n-Übergangs des Einzelphotonendetektors durch Hochenergie-Ionenimplantation erzeugt wird.

Vorteilhaft hieran ist, dass das Verfahren technisch einfach ist. Zudem ist die Ausführung des Verfahrens kostengünstig. Zudem kann die hergestellte Entropiequelle besonders wenige dotierte Schichten aufweisen. Zudem kann das Verfahren auch technisch einfach auf bekannte CMOS-Prozesse übertragen werden bzw. bei diesen angewendet werden, ohne den CMOS-Prozess wesentlich zu verändern.

Gemäß einer Ausführungsform der Entropiequelle weist die Entropiequelle mindestens zwei Photonenquellen und/oder mindestens zwei Einzelphotonendetektoren auf, wobei die Photonenquellen und/oder die Einzelphotonendetektoren in dem gemeinsamen Substrat aus dem Halbleitermaterial angeordnet sind. Vorteilhaft hieran ist, dass die Entropiequelle sehr kompakt ist. Zudem kann die Entropiequelle eine besonders hohe Entropie zur Verfügung stellen. Die Entropiequelle kann beispielsweise für zwei integrierte Quanten-Zufallszahlengeneratoren ausgebildet sein. Die von den integrierten Quanten-Zufallszahlengeneratoren erzeugten Zufallszahlen können beispielsweise miteinander verarbeitet werden, um eine einzige Zufallszahl zu erzeugen. Es ist insbesondere denkbar, dass eine (gemeinsame) Photonenquelle und zwei (oder mehr) Einzelphotonendetektoren vorhanden sind oder dass zwei (oder mehr) Photonenquellen und ein (gemeinsamer) Einzelphotonendetektoren vorhanden ist. Die Einzelphotonendetektoren können jeweils eine mittels Hochenergie-Ionenimplantation erzeugte dotierte Schicht als Teil eines p-n-Übergangs umfassen. Die Photonenquellen und die Einzelphotonendetektoren können jeweils in vertikaler Richtung übereinander in einem gemeinsamen Substrat aus einem Halbleitermaterial angeordnet sein.

Gemäß einer Ausführungsform der Entropiequelle ist die Entropiequelle in einem Substrat eines indirekten Halbleiters, insbesondere in einem Silizium-Substrat, ausgebildet ist. Vorteilhaft hieran ist, dass das Substrat technisch einfach und kostengünstig herstellbar ist. Dies senkt die Herstellungskosten der Entropiequelle.

Gemäß einer Ausführungsform der Entropiequelle ist die Entropiequelle in einem BCD-Substrat in BCD-Technologie ausgebildet. Ein Vorteil hiervon ist, dass die Entropiequelle besonders kostengünstig und einfach herstellbar ist.

Gemäß einer Ausführungsform der Entropiequelle ist eine Schicht des p-n-Übergangs des Einzelphotonendetektors mit einer Schicht des p-n-Übergangs der Photonenquelle identisch. Somit gibt es eine Schicht, die der Einzelphotonendetektor und die Photonenquelle gemeinsam haben. Hierdurch ist die Zahl der notwendigen dotierten Schichten bzw. Gebiete in der Entropiequelle für den integrierten Quanten-Zufallszahlengenerator noch weiter verringert. Dies vereinfacht den Herstellungsprozess und verringert folglich die Herstellungskosten.

Gemäß einer Ausführungsform der Entropiequelle ist der Teil des Substrats, in dem die Photonenquelle und der Einzelphotonendetektor angeordnet sind, ein nicht-epitaktisch erzeugter Teil des Substrats. Vorteilhaft hieran ist, dass das Substrat, in dem die Entropiequelle ausgebildet ist, technisch besonders einfach herstellbar ist. Dies senkt die Herstellungskosten der Entropiequelle weiter.

Gemäß einer Ausführungsform der Entropiequelle ist das Substrat, in dem die Photonenquelle und der Einzelphotonendetektor ausgebildet sind, ein CMOS-Substrat. Vorteilhaft hieran ist, dass in dem CMOS-Substrat weitere Bauelemente effizient angeordnet werden können. Somit kann der integrierte Quanten-Zufallsgenerator technisch einfach mit weiteren Bauelementen kombiniert werden. Zudem kann die Entropiequelle mittels üblicher CMOS-Techniken hergestellt werden. Insbesondere ist es möglich, dass die Entropiequelle gegenüber üblichen CMOS nur ein zusätzliches Modul in Form eines retrograden Hochenergie-Ionenimplantationsprofils zur Erzeugung des p-n-Übergangs des Einzelphotonendetektors aufweist.

Gemäß einer Ausführungsform der Entropiequelle wurde die mittels Hochenergie-Ionenimplantation erzeugte dotierte Schicht des Einzelphotonendetektors ohne einen Maskenprozess erzeugt. Vorteilhaft hieran ist, dass kein aufwendiger Maskenprozess notwendig ist. Dies vereinfacht die Herstellung der Entropiequelle. Vorstellbar hierbei ist, dass die durch Hochenergielonenimplantation erzeugte Schicht sich über die gesamte Breite des Substrats bzw. des mittels Hochenergie-Ionenimplantation bearbeiteten Teils des Substrats erstreckt.

Gemäß einer Ausführungsform der Entropiequelle wurde die mittels Hochenergie-Ionenimplantation erzeugte dotierte Schicht des Einzelphotonendetektors mit Hilfe eines Maskenprozesses erzeugt. Ein Vorteil hiervon ist, dass der Einzelphotonendetektor bzw. die Schichten des Einzelphotonendetektors technisch besonders präzise unterhalb der Photonenquelle erzeugt werden können. Folglich hat der Einzelphotonendetektor eine hohe Effizienz, da der Einzelphotonendetektor derart zu der Photonenquelle ausgerichtet werden kann bzw. derart unterhalb der Photonenquelle angeordnet sein kann, dass möglichst viele erzeugte Photonen von der Photonenquelle auf möglichst kurzem Wege zu dem Einzelphotonendetektor gelangen. Hierdurch ergibt sich eine besonders gute Kopplung zwischen der Photonenquelle und dem Einzelphotonendetektor.

Gemäß einer Ausführungsform der Entropiequelle weist der Einzelphotonendetektor nur auf der der Photonenquelle zugewandten Seite des Einzelphotonendetektors einen p-n-Übergang auf. Hierdurch ist die Anzahl der Schichten des Einzelphotonendetektors weiter reduziert. Somit ist sowohl der Herstellungsprozess als auch die elektrische Verwendung des Bauelements weiter vereinfacht.

Gemäß einer Ausführungsform der Entropiequelle besteht der Einzelphotonendetektor aus genau zwei oder genau drei dotierten Schichten. Vorteilhaft hieran ist, dass die Entropiequelle wenige dotierte Schichten aufweist und somit technisch noch einfacher aufgebaut ist. Bei den angegebenen genau zwei Schichten bzw. den angegebenen drei Schichten sind Schichten zur niederohmigen Kontaktierung der Substratoberfläche zur Bereitstellung einer Versorgungsspannung des Einzelphotonendetektors nicht mitgezählt.

Gemäß einer Ausführungsform der Entropiequelle weist der integrierte Quanten-Zufallszahlengenerator eine tiefe Grabenisolation auf, die im Wesentlichen parallel zu der vertikalen Richtung verläuft. Hierdurch werden die Schichten bzw. Gebiete der Entropiequelle effizient gegenüber benachbarten Bauelementen abgeschirmt. Somit kann die Entropiequelle in einem geringen Abstand zu weiteren Bauelementen angeordnet werden, ohne die Effizienz der Entropiequelle zu verringern.

Gemäß einer Ausführungsform der Entropiequelle weist die Photonenquelle einen p-n-Übergang auf, dessen Grenzfläche senkrecht zur vertikalen Richtung verläuft. Hierdurch wird die Herstellung weiter vereinfacht.

Gemäß einer Ausführungsform der Entropiequelle weist die Photonenquelle einen p-n-Übergang auf, dessen Grenzfläche parallel zur vertikalen Richtung verläuft. Vorteilhaft hieran ist, dass die Herstellung besonders einfach ist.

Gemäß einer Ausführungsform der Entropiequelle ist der Einzelphotonendetektor in einer tiefliegenden Hochvolt-n-Wanne (HDNW) angeordnet. Vorteilhaft hieran ist, dass die p-n-Übergänge der Photonenquelle und des Einzelphotonendetektors besonders gut gegen äußere Einflüsse geschützt sind.

Gemäß einer Ausführungsform der Entropiequelle besteht die Entropiequelle aus fünf dotierten Schichten in einem Substrat. Somit ist die Entropiequelle technisch einfach und schnell herstellbar.

Gemäß einer Ausführungsform der Entropiequelle ist der p-n-Übergang des Einzelphotonendetektors beabstandet zu der Grenze zwischen dem Substratträger selbst und dem mittels Epitaxie auf den Substratträger aufgebrachtem Substrat angeordnet. Ein Vorteil hiervon ist, dass die Entropiequelle besonders effizient ist.

Gemäß einer Ausführungsform der Entropiequelle ist die jeweilige nicht-gemeinsame Schicht des p-n-Übergangs der Photonenquelle und des p-n-Übergangs des Einzelphotonendetektors jeweils stärker dotiert als die gemeinsame Schicht, die sowohl Teil des p-n-Übergangs der Photonenquelle als auch Teil des p-n-Übergangs des Einzelphotonendetektors ist. Vorteilhaft hieran ist, dass die Durchbruchsspannung herabgesetzt ist.

Gemäß einer Ausführungsform der Entropiequelle ist die mittels Hochenergie-Ionenimplantation erzeugte dotierte Schicht des p-n-Übergangs derart ausgebildet und angeordnet, dass die mittels Hochenergie-Ionenimplantation erzeugte dotierte Schicht des p-n-Übergangs einen Teil des Substrats gegenüber dem übrigen Teil des Substrats isoliert. Vorteilhaft hieran ist, dass bei der BCD-Technologie der nMOS-Teiltransistor vom Substrat, insbesondere vom p-Substrat, das sich unterhalb der mittels Hochenergie-Ionenimplantation erzeugten dotierten Schicht des p-n-Übergangs bzw. das sich auf der von dem nMOS-Teiltransistor abgewandten Seite der mittels Hochenergielonenimplantation erzeugten dotierten Schicht des p-n-Übergangs befindet, isoliert ist. Somit lassen sich weitere Bauelemente in demselben Substrat ausbilden bzw. anordnen. Dadurch lassen sich insbesondere auch die Ansteuerung sowie auch die Spannungsversorgung für den Betrieb sowohl der Photonenquelle (z.B. Zener-avLED) als auch des Einzelphotonendetektors (z.B. SPAD Einzelphotonendetektor) auf demselben Substrat realisieren.

Gemäß einer Ausführungsform der Entropiequelle umfasst die Entropiequelle ferner eine zwischen der Photonenquelle und dem Einzelphotonendetektor angeordnete dotierte Schicht (HPW-Schicht, HVPW-Schicht) zum Einstellen des Widerstandswerts zwischen der Photonenquelle und dem Einzelphotonendetektor. Vorteilhaft hieran ist, dass der Widerstandswert durch die Breite der dotierten Schicht technisch einfach eingestellt werden kann. Zudem kann ein sogenannter Quenching-Widerstand des Einzelphotonendetektors bzw. für den Einzelphotonendetektor im Volumen des Substrats (insbesondere des Silizium-Substrats) bzw. in der Epitaxieschicht, in dem der Einzelphotonendetektor angeordnet ist, angeordnet werden. Somit ist die Entropiequelle besonders kompakt.

Gemäß einer Ausführungsform des Verfahrens wird bei der Hochenergie-Ionenimplantation keine Maske verwendet. Vorteilhaft hieran ist, dass das Herstellungsverfahren technisch besonders einfach ist.

Gemäß einer Ausführungsform des Verfahrens wird die mittels Hochenergie-Ionenimplantation erzeugte dotierte Schicht des p-n-Übergangs derart erzeugt, dass die mittels Hochenergielonenimplantation erzeugte dotierte Schicht des p-n-Übergangs einen Teil des Substrats gegenüber dem übrigen Teil des Substrats isoliert. Ein Vorteil hiervon ist, dass technisch einfach eine tiefliegende Schicht (z.B. DNW-Schicht) erzeugt werden kann, die einen Teil des Substrats gegenüber dem übrigen Teil des Substrats isoliert. Hierdurch können mehrere voneinander unabhängige Bauelemente in demselben Substrat angeordnet werden. Insbesondere kann die Ansteuerung sowie auch die Spannungsversorgung für den Betrieb sowohl der Photonenquelle (z.B. Zener-avLED) als auch des Einzelphotonendetektors (z.B. SPAD Einzelphotonendetektor) auf demselben Substrat realisiert werden.

Gemäß einer Ausführungsform des Verfahrens umfasst das Verfahren ferner folgenden Schritt: Erzeugen einer zwischen der Photonenquelle und dem Einzelphotonendetektor angeordneten dotierten Schicht zum Einstellen des Widerstandswerts zwischen der Photonenquelle und dem Einzelphotonendetektor. Ein Vorteil hiervon ist, dass Widerstandswert durch die Breite der erzeugten dotierten Schicht bzw. durch Variation der Breite der dotierten Schicht technisch einfach und präzise eingestellt werden kann. Darüber hinaus kann durch dieses Verfahren ein sogenannter Quenching-Widerstand des Einzelphotonendetektors bzw. für den Einzelphotonendetektor in demselben Volumen des Substrats (insbesondere des Silizium-Substrats) bzw. in der Epitaxieschicht, in dem bzw. in der auch der Einzelphotonendetektor angeordnet ist, erzeugt werden. Folglich kann eine Entropiequelle hergestellt werden, die besonders wenig Volumen bzw. Raum benötigt.

Gemäß einer Ausführungsform des Verfahrens wird die Entropiequelle derart hergestellt, dass eine Schicht des p-n-Übergangs des Einzelphotonendetektors mit einer Schicht des p-n-Übergangs der Photonenquelle identisch ist. Durch dieses Verfahren kann die Entropiequelle technisch besonders einfach und schnell hergestellt werden.

Das Substrat kann ein p-Substrat umfassen oder sein. Vorstellbar ist jedoch auch ein n-Substrat.

Der Photonendetektor kann insbesondere unmittelbar an die Photonenquelle gekoppelt sein.

Der Einzelphotonendetektor kann insbesondere eine Einzelphotonen-Lawinendiode (engl. SPAD; single photon avalanche diode) umfassen oder sein.

Die Oberfläche des Substrats kann im Bereich der Entropiequelle mit einer Silizid-Schicht und oberhalb dieser wiederum mit einer Metallisierung bedeckt sein. Hierdurch werden Photonen zurückgespiegelt und ein Einbringen von Photonen in die Entropiequelle kann verhindert bzw. erschwert werden.

Unter dem Begriff "Substrat" kann insbesondere der gesamte Halbleiter-Chip als Körper verstanden werden, in dem beispielsweise mittels CMOS- oder anderer Technologien eine bestimmte Elementstruktur beispielsweise durch Erzeugen von unterschiedlich dotierten Wannen oder Schichten bzw. Gebieten in dem Halbleitermaterial gebildet wird. Die Erzeugung kann alternativ oder zusätzlich additiv durch Aufbringen von weiteren Schichten und Strukturen bzw. durch eine Abfolge von Ätz- und/oder Aufbringschritten für solche weiteren Schichten und Strukturen erfolgen. Das Substrat kann daher insbesondere als materieller Träger für die Halbleiterstrukturen einer erfindungsgemäßen Entropiequelle und nicht nur im Sinne eines einfachen Träger- oder Grundsubstrats zum Aufbringen dieser Strukturen verstanden werden.

Der Einzelphotonendetektor kann eine Einzelphotonen-Lawinendiode (engl. Single Photon Avalanche Diode; Abkürzung SPAD) umfassen oder sein. Dies kann insbesondere ein Detektor mit hoher Empfindlichkeit bei hoher Verstärkung und einem geringen (Dunkel)Rauschen sein, der in der Lage ist, einzelne Photonen detektieren zu können. Der Einzelphotonendetektor ist typischerweise zum Empfangen der von der Photonenquelle erzeugten Photonen ausgebildet und angeordnet.

Unter BCD-Technologie kann insbesondere eine Bipolar-CMOS-DMOS-Technologie verstanden werden. Das BCD-Substrat kann ein Trägersubstrat und auf dem Trägersubstrat epitaktisch aufgebaute Schichten aufweisen.

Die Hochenergie-Ionenimplantation kann insbesondere eine lonenimplantation mit Energien von größer als 700 keV sein. Dies bedeutet, dass die Ionen auf Energien größer als 700 keV beschleunigt werden. Insbesondere kann mittels einer Hochenergie-Ionenimplantation eine dotierte Schicht des p-n-Übergangs in einer Tiefe von mehr als 1,0 µm, vorzugsweise in einer Tiefe des Substrats von mehr als 1,5 µm erzeugt werden. Bei der Hochenergie-Ionenimplantation können Ionen mit hoher Geschwindigkeit in das Substrat eingeschossen werden. Hierbei bildet sich eine tiefliegende Schicht bzw. ein tiefliegender dotierter Bereich bzw. ein tiefliegendes dotiertes Gebiet in dem Substrat aus. Die Verteilung der durch Hochenergie-Ionenimplantation erzeugten Dotierung kann typischerweise retrograd sein, d.h. das Maximum der typischerweise in Vertikalrichtung gaußförmig ausgebildeten Dotierungsstärke befindet sich nicht an oder nahe der Oberfläche des Substrats, sondern es befindet sich deutlich zu der Oberfläche des Substrats beabstandet. Insbesondere ist die Hochenergielonenimplantation von der Oberfläche eingebracht worden, an der sich die Photonenquelle befindet. Dies kann insbesondere bedeuten, dass die Ionen in einen Bereich, der später unterhalb des Bereichs der Photonenquelle liegt, eingeschossen werden, um die dotierten Schichten des Einzelphotonendetektors zu erzeugen. Typischerweise werden zunächst die tieferen Schichten, d.h. die dotierten Schichten des Einzelphotonendetektors, mittels Hochenergie-Ionenimplantation erzeugt bzw. dotiert und später die oberflächennahen Schichten (u.a. die Schichten der Photonenquelle) erzeugt bzw. dotiert.

Die Begriff Schicht, Region, Gebiet und Bereich werden synonym zueinander verwendet. Eine Schicht bzw. Region bzw. ein Gebiet bzw. Bereich kann insbesondere jeweils ein (dreidimensionaler) Teil des jeweiligen Substrats und/oder Substratträgers sein.

Der Strompuls bzw. die Strompulse des Einzelphotonendetektors kann bzw. können registriert und ausgewertet werden. Hierbei kann eine sogenannte Whitening-Operation ausgeführt werden. Durch die Whitening-Operation können (z.B. durch Kompressionsverfahren) die statistischen Eigenschaften verbessert werden. Hierbei kann die Entropie erhöht werden.

Die Ankunftszeiten der Photonen und/oder die Anzahl von Photonen pro einer bestimmten Zeiteinheit kann verwendet werden, um aus den Strompulsen eine Zufallszahl zu erzeugen. Der Strompuls kann in einen Zeit-zu-Digital-Wandler (Time-to-digital-converter; TDC) eingegeben werden.

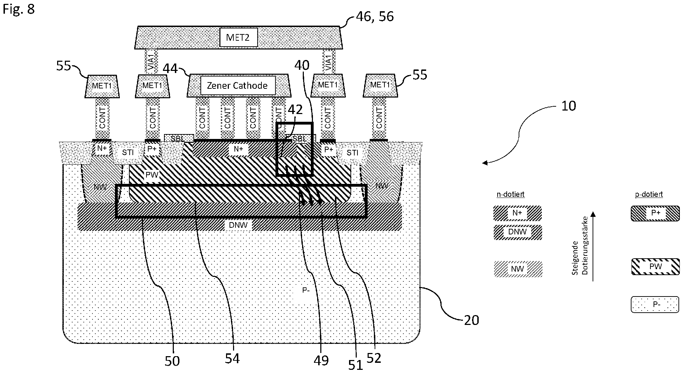

Die Entropiequelle kann insbesondere als Entropiequelle Teil einer Schaltung sein, wie sie in Fig. 8 der LU 505175 A1 gezeigt und beschrieben ist.

Die Entropiequelle kann in einem Pad-Rahmen angeordnet sein, wie dies in der LU 505175 A1 beschrieben ist.

Der integrierte Quantenzufallszahlengenerator (Abkürzung: iQRNG) kann eine elektronische Schaltung aufweisen, die die Strompulse der Entropiequelle als Eingang empfängt und daraus eine oder mehrere Zufallszahlen generiert. Die Entropiequelle erzeugt somit die notwendigen zufälligen Daten, die für die Erzeugung randomisierter Zahlen benötigt wird. Der integrierte Quanten-Zufallszahlengenerator weist somit neben der Entropiequelle weitere Bauelemente auf, die das Signal bzw. die Signale der Entropiequelle zur Erzeugung von zufälligen Zahlen verarbeiten.

Bevorzugte Ausführungsformen ergeben sich aus den Unteransprüchen. Nachfolgend wird die Erfindung anhand von einer Zeichnung eines Ausführungsbeispiels näher erläutert. Hierbei zeigen
- Fig. 1: eine schematische Darstellung einer beispielhaften ersten Ausführungsform einer erfindungsgemäßen Entropiequelle in einer Seitenansicht;
- Fig. 2: eine schematische Darstellung einer beispielhaften zweiten Ausführungsform einer erfindungsgemäßen Entropiequelle in einer Seitenansicht;
- Fig. 3: eine schematische Darstellung einer beispielhaften dritten Ausführungsform einer erfindungsgemäßen Entropiequelle in einer Seitenansicht;
- Fig. 4: eine schematische Darstellung einer beispielhaften vierten Ausführungsform einer erfindungsgemäßen Entropiequelle in einer Seitenansicht;
- Fig. 5: eine schematische Darstellung einer beispielhaften fünften Ausführungsform einer erfindungsgemäßen Entropiequelle in einer Seitenansicht;
- Fig. 6: eine schematische Darstellung für einen CMOS-Prozess ohne DNW-Schicht;
- Fig. 7: eine schematische Darstellung für einen CMOS-Prozess mit DNW-Schicht;
- Fig. 8: eine schematische Darstellung einer beispielhaften sechsten Ausführungsform einer erfindungsgemäßen Entropiequelle in einer Seitenansicht; und
- Fig. 9: eine schematische Darstellung einer Entropiequelle gemäß dem Stand der Technik in einer Seitenansicht.

Bei der nachfolgenden Beschreibung werden für gleiche und gleich wirkende Teile dieselben Bezugsziffern verwendet.

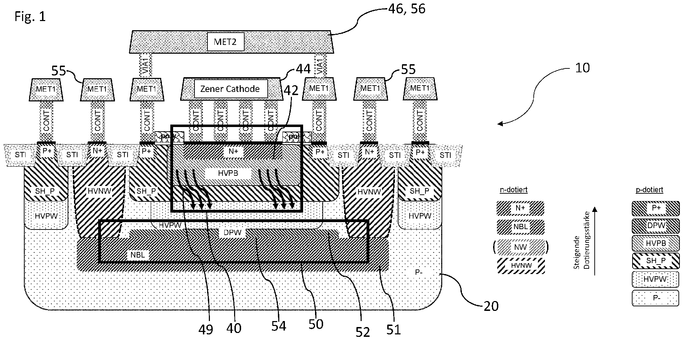

Fig. 1 zeigt eine schematische Darstellung einer beispielhaften ersten Ausführungsform einer erfindungsgemäßen Entropiequelle 10 für einen integrierten Quanten-Zufallszahlengenerator 10 (im Folgenden mit iQRNG abgekürzt) in einer Seitenansicht.

Die Dichte der Linien der schraffierten Bereiche bzw. die Dichte der Punkte in den punktierten Bereichen gibt die jeweilige Dotierungsstärke an. Je dichter die Linien bzw. Punkte sind, desto höher ist die Dotierungsstärke. Jeweils unten rechts in den Figuren ist die Dotierungsstärke der Schichten bzw. Gebiete bzw. Bereiche relativ zueinander gezeigt. Der Pfeil gibt die Richtung höherer Dotierungsstärke der Schichten an. Die relative Dotierungsstärke ist für n-dotierte Bereiche bzw. Schichten und für p-dotierte Bereiche bzw. Schichten getrennt angegeben. Eine n-Schicht und eine p-Schicht, die im Wesentlichen eine gleichhohe Dotierungsstärke aufweisen, befinden sich dabei auf der im Wesentlichen gleichen Höhe zueinander. Bei der Darstellung jeweils unten rechts in der Zeichnung sind weggelassene bzw. gesparte Schichten bewusst als Lücke gelassen, so dass erkennbar ist, welche Schichten in der jeweiligen Ausführungsform weggelassen wurden.

Die Breite des Substrats verläuft allen Zeichnungen von rechts nach links bzw. umgekehrt.

Die Entropiequelle 10 kann Teil eines integrierten Quanten-Zufallszahlengenerator sein, d.h. die Entropiequelle kann das Herzstück, das die zufälligen Daten und somit den "echten Zufall" erzeugt, eines integrierten Quanten-Zufallszahlengenerator sein. Die weiteren Bauelemente des integrierten Quanten-Zufallszahlengenerator sind in den Zeichnungen nicht gezeigt. Diese sind in der der LU 505175 genauer beschrieben, die durch Bezug hierin vollständig aufgenommen ist und auf die hier nochmals explizit, um Wiederholungen zu vermeiden, verwiesen wird. Dies gilt für die erste Ausführungsformen und für alle weiteren Ausführungsformen.

Die Entropiequelle 10 umfasst eine Photonenquelle 40 und einen Einzelphotonendetektor 50. Insbesondere weist die Entropiequelle 10 genau eine Photonenquelle 40 und genau einen Einzelphotonendetektor 50 auf.

Die Photonenquelle 40 und der Einzelphotonendetektor 50 sind in vertikaler Richtung übereinander angeordnet. Die vertikale Richtung verläuft in den Zeichnungen von oben nach unten. Die Photonenquelle 40 befindet sich typischerweise oberhalb des Einzelphotonendetektors 50, d.h. die Photonenquelle 40 befindet näher an der Oberfläche des Substrats 20 als der Einzelphotonendetektor 50. Dies bedeutet, dass der Abstand zwischen der Photonenquelle 40 und der Oberfläche des Substrats 20 kleiner ist als der Abstand zwischen dem Einzelphotonendetektor 50 und der Oberfläche des Substrats 20. Die Oberfläche des Substrats 20 befindet sich in den Zeichnungen oben.

Die Photonenquelle 40 und der Einzelphotonendetektor 50 sind in einem gemeinsamen Substrat 20 angeordnet. Auf der Oberfläche des Substrats 20 sind die Anschlüsse der Photonenquelle 40 und des Einzelphotonendetektors 50 angeordnet.

Die Photonenquelle 40 weist einen p-n-Übergang 42 auf, d.h. einen Übergang von einer p-dotierten Schicht zu einer n-dotierten Schicht bzw. von einer n-dotierten Schicht zu einer p-dotierten Schicht.

Das Substrat 20 in Fig. 1 ist ein BCD-Substrat bzw. ein Substrat, das in BCD-Technologie hergestellt wurde. Das Substrat 20 kann insbesondere ein p-Substrat bzw. ein P-Substrat sein. Das Substrat 20 ist teilweise epitaktisch bzw. mittels Epitaxie hergestellt. Insbesondere der Bereich, in dem die Photonenquelle 40 angeordnet ist, ist epitaktisch hergestellt.

Beispielhaft kann die Entropiequelle 10 folgendermaßen hergestellt werden. Zunächst wird ein Trägersubstrat bereitgestellt. Ein erster Dotierstoff wird in die Oberfläche des Trägersubstrats eingebracht, um ein erstes Gebiet 51 (z.B. NBL) vom ersten Leitungstyp (negativ für NBL) auszubilden. Anschließend wird ein Aufwachsen einer epitaktischen Schicht auf dem Trägersubstrat ausgeführt. Später wird durch Ionenimplantation eine tiefliegende Schicht bzw. ein tiefliegendes zweites Gebiet 52 (z.B. DPW) vom zweiten Leitungstyp (positiv für DPW) erzeugt, die bzw. das zu der ersten Schicht bzw. zu dem ersten Gebiet 51 unmittelbar benachbart ist. Hierdurch wird der p-n-Übergang 54 des Einzelphotonendetektors 50 erzeugt. Zudem werden durch Einbringen von Dotierstoffen weitere Schichten bzw. Gebiete in der Oberfläche oder nahe der Oberfläche des epitaktisch aufgetragenen Teils des Substrats 20 erzeugt.

Unter dem Begriff "tiefliegend" kann insbesondere verstanden werden, dass die jeweilige Schicht sich nicht an der Oberfläche des Substrats 20 der Entropiequelle 10 befindet.

Es ist auch denkbar, dass die jeweilige Dotierung bzw. der jeweilige Leitungstyp vertauscht wird. Dies bedeutet, dass das erste Gebiet 51 positiv dotiert ist und das durch Ionenimplantation erzeugte tiefliegende zweite Gebiet 52 bzw. die durch lonenimplantation erzeugte tiefliegende Schicht negativ dotiert ist. Hierdurch ergibt sich ebenfalls ein p-n-Übergang 54 des Einzelphotonendetektors 50.

Das zweite Gebiet 52 (DPW), das durch Ionenimplantation erzeugt wird, wird in einer Aufsicht von oben vollständig von dem ersten Gebiet 51 (NBL) überlagert. Dies bedeutet insbesondere, dass von oben betrachtet an jedem Punkt des zweiten Gebiets 52 sich ein Teil des ersten Gebiets 51 unterhalb des zweiten Gebiets 52 befindet.

Die erste Ausführungsform der Entropiequelle 10 unterscheidet sich von der Entropiequelle 10 gemäß dem Stand der Technik (der in Fig. 9 gezeigt) durch folgendes:
Die Entropiequelle 10 weist keine PBL-Schicht bzw. keine PBL-Teilschichten oberhalb und unterhalb der NBL-Schicht auf. Stattdessen weist die Entropiequelle 10 eine DPW-Schicht (engl. deep p-well) oberhalb der NBL-Schicht als Teil des p-n-Übergangs 54 auf. Der Einzelphotonendetektor 50 ist eine tiefliegende SPAD, auch deepSPAD genannt. Die deepSPAD umfasst einen p-n-Übergang 54 zwischen dem ersten Gebiet 51 bzw. der ersten Schicht (NBL-Schicht) und dem zweiten Gebiet 52 bzw. der zweiten Schicht (DPW-Schicht). Die DPW-Schicht ist unmittelbar angrenzend an die NBL-Schicht angeordnet. Die DPW-Schicht ist auf der der Photonenquelle 40 zugeordneten Seite der NBL-Schicht angeordnet. Die DPW-Schicht kann beispielsweise in einer Tiefe von mehr als 1,0 µm, vorzugsweise mehr als 1,5 µm, erzeugt werden. Insbesondere kann die DPW-Schicht mittels Bor-Hochenergielonenimplantation erzeugt werden.

Die Entropiequelle 10 weist somit folgende n-dotierte Schichten bzw. Gebiete auf: N+, NBL, NW und HVNW/NEPI, wobei die Dotierungsstärke der Schichten bzw. Gebiete in der genannten Reihenfolge abnimmt. Zudem weist die Entropiequelle 10 folgende p-dotierte Schichten bzw. Gebiete auf: P+, PBL, HVPB, SH_P, HVPW und P-, wobei die Dotierungsstärke der Schichten bzw. Gebiete in der genannten Reihenfolge abnimmt und wobei P- das Substrat ist. Die PBODY-Schicht im Stand der Technik wurde durch die HVPB-Schicht ersetzt. Die PW-Schicht (P-Wanne, eng. p-well) im Stand der Technik wurde durch eine oberflächennahe, flache ("shallow") p-dotierte Schicht SH_P ersetzt. Anstelle der HPW-Schichten im Stand der Technik (siehe Fig. 9) sind bei dieser Ausführungsform jeweils HVPW-Schichten (Hochvolt-p-Wanne; engl. high voltage p-well) vorhanden.

Die NW-Schicht wird bei der erfindungsgemäßen Entropiequelle in Fig. 1 nicht genutzt, jedoch ist diese bei Substraten der CMOS-Technologie grundsätzlich vorhanden. Daher ist diese NW-Schicht bei der Übersicht der Dotierungsstärken eingeklammert dargestellt.

Die PBL-Schichten unterhalb von den unter MET1 angeordneten P+-Schichten bzw. genauer ausgedrückt unterhalb der HPW-Schichten, die sich wiederum unter der jeweiligen PW-Schicht befindet, die sich wiederum unter der jeweiligen P+-Schicht befindet, wurden an beiden Rändern der Fig. 1 jeweils weggelassen. An dieser Stelle befindet sich das p-Substrat, welches ohne weiteren Übergang vom ursprünglichen Ausgangssubstrat in die ebenfalls schwach dotierte Epitaxieschicht übergeht.

Die SH_P-Schicht ist in Fig. 1 im Innenbereich der beiden HVNW-Gebiete bzw. HVNW-Schichten zu diesen beabstandet ausgebildet.

Die HPW-Schicht bzw. die HVPW-Schicht verbindet jeweils die flachen bzw. näher der Oberfläche des Substrats angeordneten p-Schichten (PW-Schicht bzw. SH_P-Schicht) mit den sehr tiefen p-Schichten (PBL-Schicht bzw. DPW-Schicht) bzw. ist zwischen diesen angeordnet. Durch die Ausgestaltung der Breite der HPW-Schicht bzw. der HVPW-Schicht kann der Widerstand bzw. der Widerstandswert zum p-n-Übergang des Einzelphotonendetektors (50) gezielt variiert werden. Damit ist es grundsätzlich möglich, einen Teil oder sogar den gesamten sogenannten Quenching-Widerstand zum Betrieb des Einzelphotonendetektors 50 bzw. für den Einzelphotonendetektor 50 auch im Volumen des Substrats (insbesondere des Silizium-Substrats) bzw. in der Epitaxieschicht zu hinterlegen bzw. anzuordnen.

Zudem ist in Fig. 1 keine NEPI-Schicht zwischen der SH_P-Schicht und der DPW-Schicht bzw. der NBL-Schicht vorhanden, während sich im Stand der Technik (vgl. Fig. 9) hier zwischen der PW-Schicht und der oberen PBL-Schicht bzw. NBL-Schicht eine HVNW/NEPI-Schicht, in der die HPW-Schicht eingebettet war, befand.

Insbesondere weist der Einzelphotonendetektor 50 genau zwei Schichten auf, nämlich die NBL-Schicht und die DPW-Schicht auf. Somit weist der Einzelphotonendetektor 50 genau einen p-n-Übergang 54 auf. Auf der der Photonenquelle 40 abgewandten Seite der NBL-Schicht ist keine weitere dotierte Schicht angeordnet bzw. vorhanden. Dies bedeutet, dass kein weiterer p-n-Übergang auf der Seite des Einzelphotonendetektors 50 ausgebildet ist, die der Photonenquelle 40 abgewandt ist.

Die Photonenquelle 40 umfasst oder ist eine Zener-Dioden-Avalanche-LED (Zener-avLED). Die Zener-avLED umfasst oder ist eine an einem Arbeitspunkt unterhalb oder nahe der Durchbruchspannung betriebene lichtemittierende Avalanche Zener-Diode.

Die Zener-avLED erzeugt einzelne Photonen, die von dem Einzelphotonendetektor 50 erfasst werden. Die einzelnen Photonen 49 werden vorzugsweise in Richtung des Einzelphotonendetektors 50 emittiert. Die Photonen 49 werden durch den p-n-Übergang 54 des Einzelphotonendetektors 50, d.h. dem Übergang von der DPW-Schicht zu der NBL-Schicht, erfasst.

Die Photonenquelle 40 umfasst eine N+-Schicht und anstelle einer PBODY-Schicht eine HVPB-Schicht (engl. high voltage p-body). Die HVPB-Schicht grenzt unmittelbar an die SH_P-Schicht an. Der p-n-Übergang 42 der Zener avLED ist der Übergang von der HVPB-Schicht zu der N+-Schicht. Die HVPB-Schicht ist wannenförmig ausgebildet und die N+-Schicht ist darin eingebettet. Zwischen der HVPB-Schicht und der HVPW-Schicht ist eine SH_P-Schicht angeordnet. Präziser ausgedrückt ist die SH_P-Schicht wannenförmig ausgebildet und die HVPW-Schicht ist in dieser Wanne eingebettet. Sowohl die SH_P-Schicht als auch die HVPW-Schicht erstrecken sich jeweils im Wesentlichen bis an die (in Fig. 1 obere) Oberfläche des Substrats 20. Die N+-Schicht befindet sich teilweise oder vollständig an der Oberfläche des Substrats 20 bzw. befindet sich abgesehen von einer Metallisierung teilweise oder vollständig an der Oberfläche des Substrats 20.

Anstelle der PW-Schicht und unter der PW-Schicht eine HPW-Schicht aufweisend weist die Entropiequelle 10 gemäß dieser Ausführungsform eine SH_P-Schicht und darunter jeweils eine HVPW-Schicht auf. Dies bedeutet, dass die SH_P-Schicht die PW-Schicht und die HVPW-Schicht die HPW-Schicht ersetzt hat gegenüber dem Stand der Technik (vgl. Fig.96).

Zur Erreichung einer hohen Durchbruchspannung (in der Regel oberhalb von 15 V), welche zum Betrieb des Einzelphotonendetektors notwendig ist, kann die DPW-Schicht seitlich zu den jeweiligen HVNW-Schichten beabstandet sein, d.h. zwischen der DPW-Schicht und der jeweiligen HVNW-Schicht ist ein Teil des p-Substrats 20 angeordnet.

Gleiches gilt für den Abstand der flachen SH_P Schicht zu den HVNW-Schichten sowohl im Bereich der NBL-Schicht 51 als auch außerhalb. Gleiches gilt für den Abstand der mitteltiefen HVPW-Schicht zu den HVNW-Schichten sowohl im Bereich der NBL-Schicht 51 als auch außerhalb.

Der jeweilige Abstand der p-Schichten (SH_P, HVPW, DPW) zu den HVNW-Schichten kann entweder identisch oder unterschiedlich gewählt sein. So ist es möglich, dass auch zwischen der DPW-Schicht und der SH_P-Schicht an den Stellen, an denen die HVPW-Schicht nicht vorhanden ist, ein Teil des p-Substrats 20 angeordnet, ist.

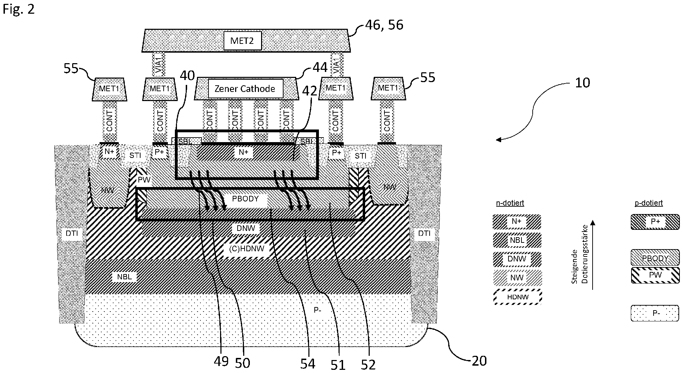

Auch die inneren und äußeren Abstände der flachen und mitteltiefen p-Schichten (hier SH_P und HVPW) zu den HVNW-Gebieten im Randbereich der Entropiequelle 10 können jeweils entweder identisch oder auch unterschiedlich gewählt sein. Entsprechende Abstände der p-Schichten (SH_P, HVPW, DPW) zur einer NW-Schicht sind ebenfalls vorzusehen, wenn (innerhalb der HVNW-Schicht) der Kathodenbereich zusätzlich mit einer höher dotierten n-Schicht (NW) versehen ist. In Fig. 1 ist diese nicht vorhanden, aber in den Figuren 2-5 und Figur 8 der weiteren Ausführungsbeispiele.

Die tiefe DPW-Schicht ist mittels Hochenergie-Ionenimplantation erzeugt worden. Hierdurch wurde ein Teil des p-Substrats dotiert und so die DPW-Schicht erzeugt.

Die Anode 46 der Photonenquelle 40 und die Anode 56 des Einzelphotonendetektors 50 sind zusammengelegt. Die Anoden 46, 56 können über eine gemeinsame zweite Metallisierung MET2 an der Oberfläche des Substrats 20 elektrisch kontaktiert werden. Eine über den kompletten Bereich des Einzelphotonendetektors 54 (und vorzugsweise auch darüberhinausgehende) durchgehende zweite oder höhere Metallisierung kann auch als Abschirmung der Entropiequelle 10 gegen äußere Einflüsse (Licht, EMV) dienen. Dies gilt auch für den Fall, wenn diese durchgehende Metallisierung nicht mit der gemeinsamen Anode verbunden sein sollte, insbesondere kann sie mit eine der beiden Kathoden (der avLED oder des Einzelphotonendetektors) verbunden sein oder floatend gehalten werden. Die jeweiligen Kathoden 44, 55 können über eine erste Metallisierung MET1 elektrisch kontaktiert werden bzw. sein. Es ist auch denkbar alle Anschlüsse (gemeinsame Anode und jeweilige Kathoden) in nur einer Metallisierung auszuführen.

Die Entropiequelle 10 weist somit nur wenige einzubringende Schichten auf und ist technisch einfach aufgebaut.

Fig. 2 zeigt eine schematische Darstellung einer beispielhaften zweiten Ausführungsform einer erfindungsgemäßen Entropiequelle 10 in einer Seitenansicht.

Die zweite Ausführungsform in Fig. 2 unterscheidet sich von der ersten Ausführungsform in Fig. 1 durch folgendes:
Links und rechts befindet sich in der Seitenansicht eine Isolierung DTI (deep trench isolation). Die Isolierung erstreckt sich über die Höhe aller dotierten Schichten. Links und rechts der DTI Isolation wurde gegenüber der ersten Ausführungsform jeweils eine P+-Schicht und die dazugehörigen Schichten unterhalb von der P+-Schicht zur Kontaktierung des Substrats weggelassen. Diese können außerhalb der Darstellung vorhanden sein.

Die zweite Ausführungsform weist weniger dotierte Schichten als die erste Ausführungsform auf.

Die Photonenquelle 40 umfasst eine N+-Schicht bzw. einen Teil der N+-Schicht und einen Teil einer PBODY-Schicht. Zwischen der N+-Schicht und der PBODY-Schicht ist der p-n-Übergang 42 der Photonenquelle 40 ausgebildet. Der Einzelphotonendetektor 50 bzw. der p-n-Übergang 54 des Einzelphotonendetektors 50 umfasst einen Teil der PBODY-Schicht und eine DNW-Schicht bzw. einen Teil der DNW-Schicht und/oder einen Teil der PW-Schicht und die DNW-Schicht bzw. einen Teil der DNW-Schicht. Dies bedeutet, dass ein Teil der PBODY-Schicht sowohl eine Schicht bzw. einen Teil des p-n-Übergangs 42 der Photonenquelle 40 als auch eine Schicht bzw. einen Teil des p-n-Übergangs 54 des Einzelphotonendetektors 50 bildet. Dieselbe Schicht PBODY ist somit Teil der Photonenquelle 40 und Teil des Einzelphotonendetektors 50. Der Einzelphotonendetektor 50 umfasst genau zwei Schichten, nämlich die PBODY-Schicht bzw. einen Teil der PBODY-Schicht und die DNW-Schicht bzw. einen Teil der DNW-Schicht.

Die DNW-Schicht wurde mittels Hochenergie-Ionenimplantation erzeugt. Insbesondere ist es möglich, dass die DNW-Schicht in einer Tiefe von mehr als 1 µm erzeugt wird. Die DNW-Schicht kann beispielsweise mittels Phosphor-Dotierung erzeugt werden.

In dem Substrat 20 (p-Substrat) befindet sich unten eine NBL-Schicht, die sich von einer Isolierung zur anderen Isolierung bzw. von links nach rechts erstreckt. Oberhalb von der NBL-Schicht und unmittelbar angrenzend an die NBL-Schicht ist eine sogenannte C-HDNW-Schicht angeordnet.

In der topfförmigen C-HDNW-Schicht ist die DNW-Schicht eingebettet. Die C-HDNW-Schicht erstreckt sich weiter nach oben, so dass diese die PBODY-Schicht teilweise umschließt.

Alternativ kann die DNW-Schicht auch bis in den Kathodenbereich der NW-Schichten oder bis zur DTI-Isolation ausgedehnt sein. Alternativ kann dann auch die C-HDNW Schicht nicht vorhanden sein.

Seitlich der PBODY-Schicht ist im oberen Bereich der PBODY-Schicht eine PW-Schicht zwischen der PBODY-Schicht und der C-HDNW-Schicht vorhanden. Links und rechts von der PBODY-Schicht und hier unmittelbar angrenzend an diese ist die PW-Schicht ausgebildet. Zwischen der PW-Schicht und dem DTI ist jeweils ein Teil der C-HDNW-Schicht und eine NW-Schicht in der C-HDNW-Schicht angeordnet.

Wie unten rechts in Fig. 2 zu sehen, sind bei der zweiten Ausführungsform zwei p-dotierte Schichten gegenüber der ersten Ausführungsform weggelassen, nämlich die PBL-Schicht und die HVPW-Schicht. Hinzu gekommen ist eine weitere n-dotierte Schicht, nämlich die DNW-Schicht, zwischen der NBL-Schicht und der N+-Schicht.

Die NBL-Schicht ist in die Oberfläche des ursprünglichen Substratträgers durch Implantation eingebracht worden. Die weiteren, ungefähr oberhalb der NBL-Schicht liegenden Bereiche des Substrats sind in Fig. 2 durch Epitaxie aufgetragen worden. Die DNW-Schicht wurde durch Hochenergie-Ionenimplantation erzeugt.

Vorstellbar ist natürlich, dass die Dotierungen der Schichten und des Substrats jeweils vertauscht sind. Dies bedeutet, dass ein n-Substrat vorstellbar ist, in dem eine positive DPW-Schicht durch lonenimplantation erzeugt wird. Auch die weiteren Schichten können jeweils im Hinblick auf die Dotierungsart (positiv vs. negativ) vertauscht sein. Dies gilt für alle Ausführungsformen.

Zwischen der seitlichen N+-Schicht bzw. der seitlichen NW-Schicht und der oberen P+-Schicht ist jeweils eine weitere Isolierung bzw. ein Isolationsgebiet (engl. STI, shallow trench isolation) angeordnet.

Die HVPB-Schicht der ersten Ausführungsform wurde durch die PBODY-Schicht ersetzt. Die SH_P-Schicht der ersten Ausführungsform wurde durch die PW-Schicht ersetzt.

Die Entropiequelle 10 ist besonders kompakt. Zudem kann die Entropiequelle 10 durch die Isolierung nach links und rechts sehr nahe bei weiteren Bauelementen angeordnet werden, ohne dass die Entropiequelle 10 und das weitere Bauelement sich gegenseitig negativ beeinflussen. Die SBL-Schicht ("Silicide Blocking Layer") verhindert die Bildung einer Silizid-Schicht.

Die Entropiequelle 10 weist bei der zweiten Ausführungsform folgende n-dotierte Schichten, in absteigender Dotierungsstärke, auf: N+, NBL, DNW, NW, HDNW. Die Entropiequelle 10 weist bei der zweiten Ausführungsform folgende p-dotierte Schichten, in absteigender Dotierungsstärke, auf: P+, PBODY, PW, P-, wobei P- das Substrat ist.

Der p-n-Übergang 54 des Einzelphotonendetektors 50 befindet sich nicht in der Nähe der Grenze bzw. Grenzschicht zwischen dem Substratträger und dem epitaktisch bzw. durch Epitaxie aufgebrachten Teil des Substrats, sondern der p-n-Übergang 54 liegt innerhalb der epitaktisch gewachsenen Schicht. Ein typischer Bereich für die Tiefe des p-n-Übergangs 54 ist definiert im Bereich 1,0 µm bis max. 4 µm, dies ist meist im Bereich 15% bis 70% in Bezug auf die gesamte Epitaxiedicke.

Die DNW-Schicht weist eine ähnlich hohe Dotierungsstärke auf wie die NBL-Schicht auf.

Dadurch kann die Durchbruchsspannung gering (z.B. 17 Volt) sein. Die Betriebsspannung des Einzelphotonendetektors (Durchbruchspannung plus eine geringe Überspannung von wenigen Volt) kann entsprechend ebenfalls gering sein.

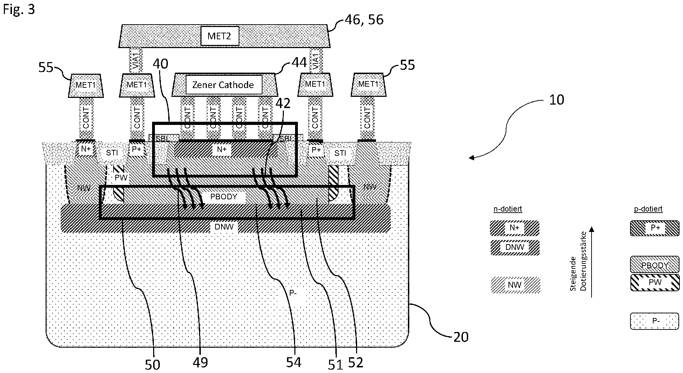

Fig. 3 zeigt eine schematische Darstellung einer beispielhaften dritten Ausführungsform einer erfindungsgemäßen Entropiequelle 10 in einer Seitenansicht.

Bei der dritten Ausführungsform der Entropiequelle 10 wurde kein Teil des Substrats durch Epitaxie aufgebracht. Die Entropiequelle 10 befindet sich vollständig in einem Substratträger. Insbesondere wurde somit bei der Herstellung kein Align-Schritt bzw. Ausrichtungsschritt zum Ausrichten nach der Epitaxie benötigt. Auch weist die Entropiequelle 10 der dritten Ausführungsform im Vergleich zur zweiten Ausführungsform keine NBL-Schicht, keine PBL-Schicht, keine C-HDWN-Schicht und keine seitlichen Isolierungen (DTI) auf.

Das Substrat 20 wurde durch BCD-Technologie hergestellt.

Ganz unten in der Entropiequelle 10 befindet sich in dem P-Substrat die DNW-Schicht. Die DNW-Schicht wurde durch Hochenergie-Ionenimplantation erzeugt. Oberhalb der DNW-Schicht und unmittelbar angrenzend and diese ist die PBODY-Schicht ausgebildet. Wie bei der zweiten Ausführungsform umfasst der Einzelphotonendetektor 50 bei der dritten Ausführungsform die DNW-Schicht und die PBODY-Schicht bzw. jeweils einen Teil hiervon. Die PBODY-Schicht ist wie bei der zweiten Ausführungsform auch bei der dritten Ausführungsform ebenfalls eine der beiden dotierten Schichten der Photonenquelle 40 bzw. bildet einen Teil des p-n-Übergangs 42 sowohl der Photonenquelle 40 als auch des Einzelphotonendetektors 50. Die Photonenquelle 40 umfasst die PBODY-Schicht und die N+-Schicht bzw. jeweils einen Teil hiervon.

Wie bei der zweiten Ausführungsform ist auch bei der dritten Ausführungsform zwischen der seitlichen N+-Schicht und der seitlichen NW-Schicht und der oberen P+-Schicht jeweils ein shallow trench isolation (STI) angeordnet.

Wie unten rechts dargestellt weist die Entropiequelle 10 nur drei n-dotierte Schichten (N+, DNW und NW) und vier p-dotierte Schichten (P+, PBODY, PW, P-) auf, wobei P- das Substrat ist. Die NBL-Schicht und die HDNW-Schicht der n-dotierten Schichten wurden gegenüber der zweiten Ausführungsform weggelassen. Die p-dotierten Schichten der dritten Ausführungsform sind gegenüber denen der zweiten Ausführungsform gleichgeblieben.

Somit weist die Entropiequelle 10 der dritten Ausführungsform noch weniger Schichten auf und ist somit technisch einfacher aufgebaut. Zudem ist die Entropiequelle 10 in einem Nicht-epi-Substrat angeordnet, d.h. einem Substrat, bei dem nicht Teile mittels Epitaxie aufgebracht wurden.

Die gemeinsame Anode 46, 56 der Photonenquelle 40 und des Einzelphotonendetektors 50 ist nicht mit dem P-Substrat verbunden. Zwischen der DNW-Schicht und dem P⁻-Substrat sind im Wesentlichen keine SPAD-Eigenschaften vorhanden.

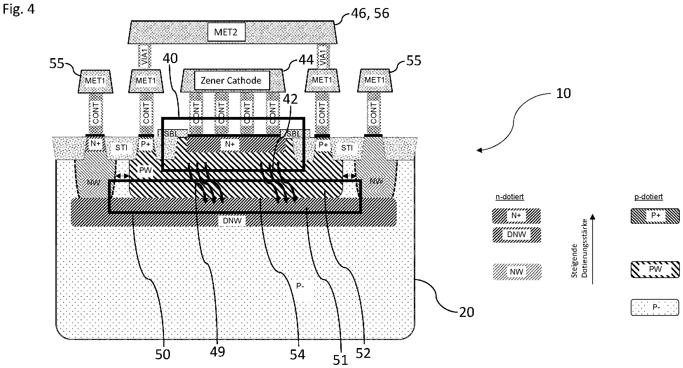

Fig. 4 zeigt eine schematische Darstellung einer beispielhaften vierten Ausführungsform einer erfindungsgemäßen Entropiequelle 10 in einer Seitenansicht.

Die vierte Ausführungsform unterscheidet sich von der dritten Ausführungsform wie folgt: Die PBODY-Schicht wurde weggelassen. An der Stelle, wo vorher die PBODY-Schicht war, befindet sich nun eine ausgedehntere PW-Schicht, die stärker dotiert ist als die PBODY-Schicht (die bei der dritten Ausführungsform noch vorhanden war). Die Photonenquelle 40 umfasst somit die N+-Schicht und die PW-Schicht bzw. jeweils einen Teil hiervon. Der Einzelphotonendetektor 50 umfasst die PW-Schicht und die DNW-Schicht bzw. einen Teil hiervon. Die PW-Schicht ist somit teilweise Teil der Photonenquelle 40 und gleichzeitig teilweise Teil des Einzelphotonendetektors 50.

Die Photonenquelle 40 umfasst oder ist bei dieser Ausführungsform eine Zener-Dioden-ähnliche Avalanche-LED. Die Durchbruchsspannung dieser Zener-avLED ist somit verschieden von der Durchbruchsspannung der ersten drei Ausführungsformen.

Die DNW-Schicht ist mittels Ionenimplantation hergestellt. Hierbei kann eine Maske bzw. ein Maskenprozess verwendet werden.

Die Durchbruchspannung des Einzelphotonendetektors 50 kann durch die Prozessparameter (lonenimplantationsenergie und Dosis) der DNW-Schicht für die Anwendung optimiert, insbesondere auf einen Wert deutlich kleiner als 40 V, vorzugsweise kleiner als 20 V oder sogar kleiner als 15 V, reduziert, werden.

Wie unten rechts in Fig. 4 gezeigt, weist die Entropiequelle 10 genau drei n-dotierte Schichten (N+, DNW, NW) und genau drei p-dotierte Schichten (P+, PW, P-) auf, wobei P- das Substrat 20 ist.

Auch bei der vierten Ausführungsform wurde keine Schicht durch Epitaxie erzeugt bzw. aufgebracht. Bei der Herstellung der Entropiequelle 10 der vierten Ausführungsform wurden kein Align-Schritt zum Ausrichten benötigt. Auch weist die Entropiequelle 10 der vierten Ausführungsform keine NBL-Schicht, keine PBL-Schicht und keine Isolierungen (DTI) auf. Das Substrat 20 wurde nicht durch BCD-Technologie hergestellt.

Das Substrat 20 kann ein CMOS-Substrat sein.

Die seitlich angeordneten NW-Schichten sind durch das P⁻-Substrat jeweils gegenüber der PW-Schicht beabstandet. Dies bedeutet, dass zwischen der linken NW-Schicht und der PW-Schicht P⁻-Substrat vorhanden ist und dass zwischen der rechten NW-Schicht und der PW-Schicht P⁻-Substrat vorhanden ist. Dies ist durch zwei Doppelpfeile in Fig. 4 jeweils hervorgehoben.

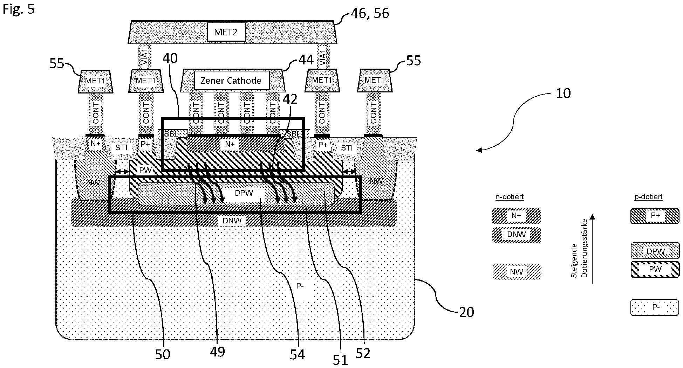

Fig. 5 zeigt eine schematische Darstellung einer beispielhaften fünften Ausführungsform einer erfindungsgemäßen Entropiequelle 10 in einer Seitenansicht.

Die in Fig. 5 gezeigte fünfte Ausführungsform unterscheidet sich von der vierten Ausführungsform nur dadurch, dass eine zusätzliche tiefe p-Wanne (DPW) oberhalb und lateral innerhalb der DNW-Schicht eingebracht ist. Die DPW-Schicht ist mittels Ionenimplantation hergestellt. Durch die eingebrachte p-Wanne wird der p-n-Übergang des Einzelphotonendetektors derart modifiziert, dass die Durchbruchspannung in einem einfach handhabbaren Bereich (typischerweise kleiner/gleich als 40 V) liegt, welcher insbesondere durch die Verwendung eines isolierenden CMOS Prozesses (DNW unterhalb CMOS) vorgegeben wird .

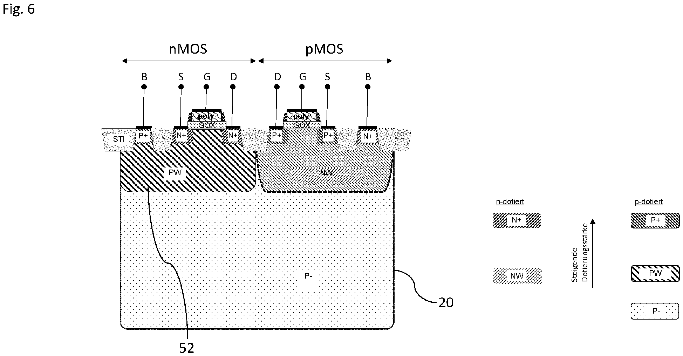

Fig. 6 zeigt eine schematische Darstellung für einen CMOS Prozess ohne DNW-Schicht.

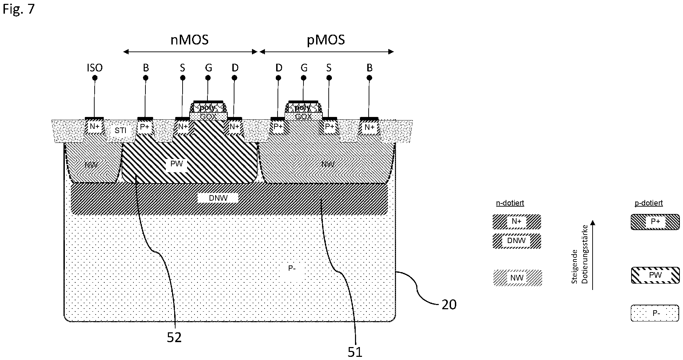

In der Fig. 6 sind die beiden typischen Bauelemente eines CMOS-Prozesses dargestellt, nämlich im linken Bereich ein nMOS-Transistor und in rechten Bereich ein pMOS-Transistor. Oberhalb bzw. am oberen Rand sind die relevanten technischen Terminals bzw. Anschlüsse Source (S), Drain (D), Gate (G) und Bulk (B) des jeweiligen Transistors angegeben. Unterhalb der Transistorgebiete wird nun eine DNW-Schicht ergänzt, welche durch Hochenergie-Ionenimplantation geformt bzw. erzeugt wird, wie dies in Fig. 7 geschehen ist. So wird ein sogenannter isolierter CMOS-Prozess bzw. isolationsfähiger CMOS-Prozess bzw. isolierender CMOS-Prozess erzeugt. Isoliert heißt in diesem Fall, dass nun auch das Bulk des nMOS-Transistors bzw. nMOS-Teiltransistors vom p-Substrat isoliert ist. Somit können neben der Entropiequelle 10 auf bzw. in demselben Substrat 20 von der der Entropiequelle 10 isolierte Bauelemente ausgebildet bzw. angeordnet werden. Für diesen nMOS-Teiltransistor kann das technische Terminal ISO ergänzt werden, wie dies in Fig. 7 gezeigt ist.

In beiden Konfigurationen (Fig. 6 und Fig. 7) werden die PW-Wanne und die NW-Wanne üblicherweise ohne Abstand zueinander angeordnet.

Durch die Verwendung von BCD-Techniken sowie auch im Fall des isolierten CMOS-Prozesses können Schaltungsteile mit deutlich erhöhter, absoluter Spannung gegenüber dem Substratpotential, d.h. hoher High-Side Spannung, realisiert bzw. hergestellt werden. Dies ist mit einem einfachen CMOS-Prozess üblicherweise nicht möglich. Dadurch lassen sich insbesondere auch die Ansteuerung sowie auch die Spannungsversorgung für den Betrieb sowohl der Photonenquelle (z.B. Zener-avLED) sowie des Einzelphotonendetektors (z.B. Single Photon Avalanche Diode; SPAD-Einzelphotonendetektor) auf dem gleichen Substrat realisieren.

Fig. 8 zeigt eine schematische Darstellung einer beispielhaften sechsten Ausführungsform einer erfindungsgemäßen Entropiequelle 10 in einer Seitenansicht.

Die fünfte Ausführungsform unterscheidet sich von der vierten Ausführungsform nur dadurch, dass alternativ oder zusätzlich ein lateraler bzw. seitlicher p-n-Übergang 54 vorhanden ist. Dieser alternative oder zusätzliche p-n-Übergang 54 ist zwischen der N+-Schicht und der PW-Schicht ausgebildet. Der zusätzliche p-n-Übergang 54 befindet sich unterhalb der SBL-Schicht. Der alternative oder zusätzliche p-n-Übergang 54 verläuft in senkrechter Richtung bzw. parallel zu der senkrechten Richtung. Die erzeugten Photonen 49 gelangen jedoch größtenteils zu dem Einzelphotonendetektor 50, d.h. nach unten.

### Bezugszeichenliste

- 10, 10': Integrierter Quanten-Zufallszahlengenerator
- 20: Substrat
- 40, 40': Photonenquelle
- 42: erster p-n-Übergang (Photonenquelle)
- 44, 44': Kathode der Photonenquelle
- 46, 46': Anode der Photonenquelle
- 49, 49': Photonen
- 50, 50': Einzelphotonendetektor
- 51, 51': erstes Gebiet des p-n-Übergangs des Einzelphotonendetektors (z.B. NBL)
- 52, 52': zweites Gebiet des p-n-Übergangs des Einzelphotonendetektors (z.B. DPW)
- 54, 54': zweiter p-n-Übergang (Einzelphotonendetektor)
- 55, 55': Kathode des Einzelphotonendetektors
- 56, 56': Anode des Einzelphotonendetektors
- NBL: tiefliegende n-Schicht (engl. "n-type buried layer")
- DNW: tiefliegende n-Wanne (engl. "deep n-type well")
- HDNW: tiefliegenden Hochvolt-n-Wanne (engl. "high voltage deep n-well")
- PBL: tiefliegende p-Schicht (engl. "p-type buried layer")
- HVPW: Hochvolt-p-Wanne (engl. "high-voltage p-type well")
- HVPB: Hochvolt p-dotierter Bereich (engl. "p-type body")
- HVNW: Hochvolt-n-Wanne (engl. "high-voltage n-type well")
- PW: p-Wanne (engl. "p-type well")
- NW: n-Wanne (engl. "n-type well")
- PBODY: p-dotierter Bereich (engl. "p-type body")
- NEPI: schwach n-dotiertes bzw. (annähernd) intrinsisches epitaktisches Gebiet
- MET1: Metallisierung 1
- MET2: Metallisierung 2
- CONT: Kontakt
- STI: Isolationsgebiet (engl. "shallow trench isolation")
- DTI: tiefes Isolationsgebiet (engl. "deep trench isolation")
- P⁺: p⁺-Gebiet
- N⁺: N⁺-Gebiet
- poly: Polysilizium-Schicht
- SH_P: flaches p-dotiertes Gebiet (engl. "shallow p-type layer")
- SBL: Silizid-Blockierungsgebiet (engl. "salicide blocking layer")

## Patentansprüche

1. Entropiequelle für einen integrierten Quanten-Zufallszahlengenerator (10) umfassend:
eine Photonenquelle (40) und
einen Einzelphotonendetektor (50),
wobei
die Photonenquelle (40) und der Einzelphotonendetektor (50) in vertikaler Richtung übereinander in einem gemeinsamen Substrat (20) aus einem Halbleitermaterial angeordnet sind,
**dadurch gekennzeichnet, dass**
der Einzelphotonendetektor (50) eine mittels Hochenergie-Ionenimplantation erzeugte dotierte Schicht als Teil eines p-n-Übergangs (54) umfasst.

2. Entropiequelle nach Anspruch 1, wobei
das Substrat (20), in dem die Photonenquelle (40) und der Einzelphotonendetektor (50) ausgebildet sind, ein CMOS-Substrat ist.

3. Entropiequelle nach Anspruch 1 oder 2, wobei
die mittels Hochenergie-Ionenimplantation erzeugte dotierte Schicht des Einzelphotonendetektors (50) ohne einen Maskenprozesses erzeugt wurde.

4. Entropiequelle nach Anspruch 1 oder 2, wobei
die mittels Hochenergie-Ionenimplantation erzeugte dotierte Schicht des Einzelphotonendetektors (50) mit Hilfe eines Maskenprozesses erzeugt wurde.

5. Entropiequelle nach einem der vorhergehenden Ansprüche, wobei
der Einzelphotonendetektor (50) nur auf der der Photonenquelle (40) zugewandten Seite des Einzelphotonendetektors (50) einen p-n-Übergang (54) aufweist.

6. Entropiequelle nach einem der vorhergehenden Ansprüche, wobei
der Einzelphotonendetektor (50) aus genau zwei oder genau drei dotierten Schichten besteht.

7. Entropiequelle nach einem der vorhergehenden Ansprüche, wobei
die Entropiequelle eine tiefe Grabenisolation (DTI) aufweist, die im Wesentlichen parallel zu der vertikalen Richtung verläuft.

8. Entropiequelle nach einem der vorhergehenden Ansprüche, wobei
der Einzelphotonendetektor (50) in einer tiefliegenden Hochvolt-n-Wanne (HDNW) angeordnet ist.

9. Entropiequelle nach einem der vorhergehenden Ansprüche, wobei
die Entropiequelle aus fünf dotierten Schichten in einem Substrat (20) besteht.

10. Entropiequelle nach einem der vorhergehenden Ansprüche, wobei
die mittels Hochenergie-Ionenimplantation erzeugte dotierte Schicht des p-n-Übergangs (54) derart ausgebildet und angeordnet ist, dass die mittels Hochenergie-Ionenimplantation erzeugte dotierte Schicht des p-n-Übergangs (54) einen Teil des Substrats (20) gegenüber dem übrigen Teil des Substrats (20) isoliert.

11. Entropiequelle nach einem der vorhergehenden Ansprüche, ferner umfassend
eine zwischen der Photonenquelle (40) und dem Einzelphotonendetektor (50) angeordnete dotierte Schicht (HPW-Schicht, HVPW-Schicht) zum Einstellen des Widerstandswerts zwischen der Photonenquelle (40) und dem Einzelphotonendetektor (50).

12. Integrierter Quanten-Zufallszahlengenerator umfassend eine Entropiequelle nach einem der vorhergehenden Ansprüche.

13. Integrierte elektronische Schaltung umfassend einen integrierten Quanten-Zufallszahlengenerator (10) nach Anspruch 12.

14. Verfahren zum Herstellen eines Entropiequelle für einen integrierten Quanten-Zufallszahlengenerators (10), insbesondere einer Entropiequelle nach einem der Ansprüche 1-11, wobei das Verfahren folgende Schritte umfasst:
Bereitstellen eines Substrats; und
Erzeugen von mehreren dotierten Schichten zur Erzeugung eines p-n-Übergangs einer Photonenquelle (40) und eines p-n-Übergangs (54) eines Einzelphotonendetektors (50) in dem Substrat,
wobei die Photonenquelle (40) und der Einzelphotonendetektor (50) in vertikaler Richtung übereinander in dem Substrat (20) angeordnet sind, und
wobei eine dotierte Schicht des p-n-Übergangs (54) des Einzelphotonendetektors (50) durch Hochenergie-Ionenimplantation erzeugt wird.

15. Verfahren nach Anspruch 14, wobei
bei der Hochenergie-Ionenimplantation keine Maske verwendet wird.

16. Verfahren nach Anspruch 14 oder 15, wobei
die mittels Hochenergie-Ionenimplantation erzeugte dotierte Schicht des p-n-Übergangs (54) derart erzeugt wird, dass die mittels Hochenergie-Ionenimplantation erzeugte dotierte Schicht des p-n-Übergangs (54) einen Teil des Substrats (20) gegenüber dem übrigen Teil des Substrats (20) isoliert.
